# EUROPEAN PATENT APPLICATION

(11) **EP 4 546 975 A1**
(43) Date of publication of application: **30.04.2025**
(21) Application number: 24207999.4
(22) Date of filing: 22.10.2024
(51) Int. Cl.: H10D 30/66, H10D 30/01, H10D 62/10

(54) **MOSFET TRANSISTOR WITH AN IMPROVED BODY STRUCTURE TO INCREASE THE ROBUSTNESS AND RELATED MANUFACTURING PROCESS**

(30) Priority: 25.10.2023 IT 202300022362
(71) Applicant: STMicroelectronics International N.V., 1228 Plan-les-Ouates, Geneva (CH)
(72) Inventor: ARCURI, Luigi, 95045 MISTERBIANCO (CT) (IT); GRIMALDI, Antonio Giuseppe, 95037 S. GIOVANNI LA PUNTA (CT) (IT)
(74) Representative: Studio Torta S.p.A.

(57) **Abstract**

MOSFET transistor with a semiconductor body (4) including a drain region (8) of a first conductivity type, delimited by a front surface (Sₜₒₚ), and at least one cell (2) including: a pair of gate structures (10) laterally offset parallel to a first axis (X) and each including a respective gate dielectric region (12), arranged on the front surface (Sₜₒₚ), and a respective gate conductive region (14), arranged on the corresponding gate dielectric region (12); a body structure (20) of a second conductivity type, which includes a body region (22), which extends inside the drain region (8) starting from the front surface (Sₜₒₚ) and contacts portions of the gate dielectric regions (12), and a strengthening region (24), which extends below the body region (22); and a pair of source regions (30',30") of the first conductivity type, which extend inside the body region (22) starting from the front surface (Sₜₒₚ). The body structure (20) includes an enriched region (23), which extends inside the body region (22), below the source regions (30',30"), and protrudes laterally, parallel to the first axis (X), in both directions with respect to the pair of source regions (30',30"). Figure 1

## Description

### Technical Field

The present invention relates to a MOSFET transistor with an improved body structure to increase the robustness and to the related manufacturing process.

### Background

As is known, there exist MOSFET transistors designed to withstand particularly high voltages; in use, these MOSFET transistors may find themselves operating for short periods in breakdown conditions. For example, when a MOSFET transistor has an inductive-type load, the MOSFET transistor may have to withstand a drain-source voltage higher than the breakdown voltage, in which case the drain-source diode that is present in the MOSFET transistor is flown through by a high reverse current. Due to such reverse current, the parasitic bipolar transistor formed by the body region, the source region and the drain region of the MOSFET transistor may be turned on, in which case a further increase in the current that flows through the MOSFET transistor may occur, with consequent destruction of the latter. These operating situations are precisely recreated during the so-called "unclamped inductive switching" (UIS) test, which aims at verifying the actual robustness of a MOSFET transistor.

US 4,587,713 discloses a vertical MOSFET including a channel region in a body region; the body region further includes a similar conductivity type supplementary region, which has a high dopant concentration and extends laterally beneath a portion of the channel region.

US 11,133,379 B2 discloses a planar gate MOSFET including an enriched region in a body region and a strengthening region extending below the body region.

US 2017/054000 A1 discloses a MOSFET including a body region, which has a width having a non-monotonic trend as the depth increases.

### Summary

The aim of the present invention is therefore to provide a MOSFET transistor that is capable of withstanding a high reverse current, without causing the turn-on of the corresponding parasitic bipolar transistor.

According to the present invention, a MOSFET transistor and a manufacturing process are provided, as defined in the attached claims.

### Brief Description of the Figures

For a better understanding of the present invention, embodiments thereof are now described, purely by way of nonlimiting example, with reference to the attached drawings, wherein:
- Figure 1 schematically shows a cross-section of a portion of a MOSFET transistor; and
- Figures 2-9 schematically show cross-sections of the MOSFET transistor shown in Figure 1, during successive steps of a manufacturing process.

### Description of Embodiments

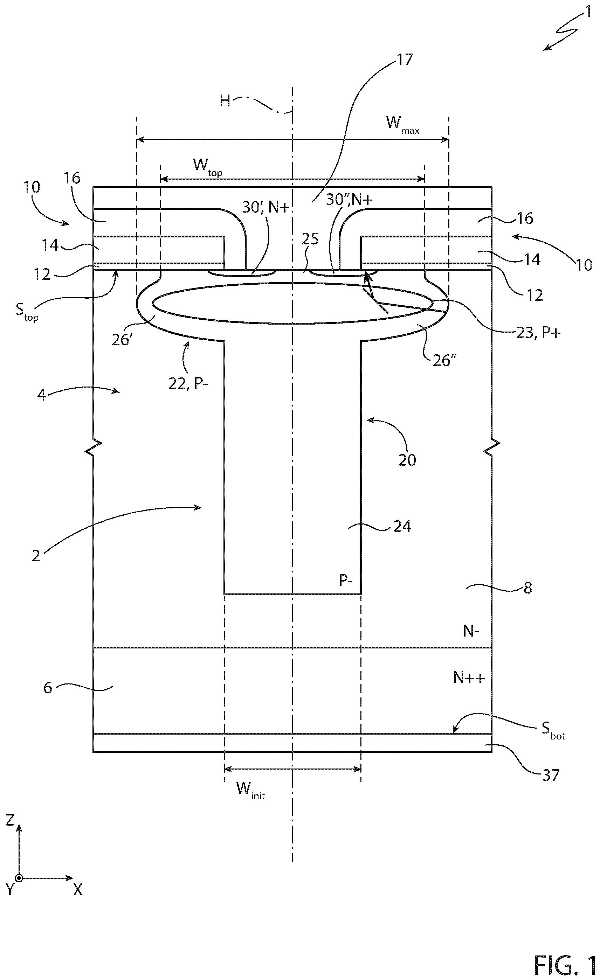

Figure 1 shows an orthogonal reference system XYZ and a MOSFET transistor 1, which comprises a semiconductor body 4, formed for example by silicon and comprising a substrate 6 and a drain region 8.

For example, the substrate 6 has an N++ type doping (for example comprised between 1*10¹⁸cm⁻³ and 9*10²⁰cm⁻³) and is delimited at the bottom by a bottom surface S_{bot}, which is approximately parallel to the XY plane. The drain region 8 has for example an N- type doping (for example, comprised between 1*10¹⁴cm⁻³ and 1*10¹⁷cm⁻³) and extends above the substrate 6, in direct contact. Furthermore, the drain region 8 is delimited at the top by a top surface Sₜₒₚ, which is approximately parallel to the XY plane.

Furthermore, the MOSFET transistor 1 comprises a plurality of gate structures 10 (two visible in Figure 1) and a plurality of body structures 20 (one visible in Figure 1) .

The gate structures 10 are approximately equal to each other, extend above the top surface Sₜₒₚ and have elongated shapes parallel to the Y axis; furthermore, the gate structures 10 are arranged laterally offset parallel to the X axis.

The body structures 20 are approximately equal to each other, extend inside the drain region 8, starting from the top surface Sₜₒₚ, and have elongated shapes parallel to the Y axis; furthermore, the body structures 20 are arranged laterally offset parallel to the X axis, in an alternate manner with respect to the gate structures 10. In other words, parallel to the X axis, each body structure 20 extends between two corresponding gate structures 10, as shown in Figure 1.

In practice, each body structure 20 forms, together with the corresponding pair of gate structures 10, a cell 2 of the MOSFET transistor 1, which is therefore formed by a plurality of cells 2 (only one visible in Figure 1), which are approximately equal to each other and are arranged, parallel to the X axis, in such a way that adjacent cells share a same gate structure 10.

In greater detail, each gate structure 10 comprises a respective gate dielectric region 12, a respective gate conductive region 14 and a respective gate insulating region 16, as described hereinbelow with reference to a single gate structure 10.

In particular, the gate dielectric region 12 extends above the top surface Sₜₒₚ, in contact with the semiconductor body 4, and is formed by a dielectric material, such as for example oxide (for example, thermal oxide). Furthermore, the gate dielectric region 12 has an approximately planar shape, elongated parallel to the Y axis.

The gate conductive region 14 extends above the gate dielectric region 12, in direct contact, and is formed for example by polysilicon. The gate conductive region 14 also has an approximately planar shape, elongated parallel to the Y axis.

The gate insulating region 16 is formed by a dielectric material, such as for example oxide (for example, silicon oxide or TEOS), and extends so as to surround the gate dielectric region 12 and the gate conductive region 14 at the top and laterally. In particular, a central portion of the gate insulating region 16 extends above the gate conductive region 14, in direct contact; furthermore, two lateral portions of the gate insulating region 16 extend on opposite sides of the gate dielectric region 12 and the gate conductive region 14, so as to laterally coat the gate dielectric region 12 and the gate conductive region 14, in direct contact, up to contacting the semiconductor body 4 at the bottom.

Although not shown, the gate conductive regions 14 are placed in electrical contact with each other in a per se known manner, so as to form the gate terminal of the MOSFET transistor 1. In order to allow the gate terminal to be electrically coupled to the outside world, the MOSFET transistor 1 may for example comprise a gate metallization (not shown) which extends through part of at least one gate insulating region 16, so as to electrically contact the corresponding gate conductive region 14. These details are however irrelevant for the operation of the MOSFET transistor 1.

The MOSFET transistor 1 further comprises a drain metallization 37, which extends below the substrate 6, in direct contact, and a source metallization 17, which extends on the gate insulating regions 16, in direct contact, and between the gate insulating regions 16, so as to contact the portions of the top surface Sₜₒₚ left exposed by the gate structures 10.

Again with reference to the body structure 20, it comprises a body region 22 and a strengthening region 24, which are described in greater detail hereinbelow; for this purpose, a symmetry plane H is introduced parallel to the YZ plane and such that the two gate structures 10 which correspond to the body structure 20 are arranged symmetrically with respect to the symmetry plane H. Furthermore, without any loss of generality, as a first approximation the body structure 20 has a section, parallel to the XZ plane, which is invariant for translations along the Y axis.

In detail, both the body region 22 and the strengthening region 24 have elongated shapes parallel to the Y axis and approximately symmetrical with respect to the symmetry plane H. Furthermore, the body region 22 and the strengthening region 24 have P- type doping (for example, comprised between 1*10¹⁴cm⁻³ and 1*10¹⁶cm⁻³).

In greater detail, the strengthening region 24 is arranged below the body region 22 and has approximately a shape of a parallelepiped with an axis parallel to the Y axis.

As regards the body region 22, it has a rounded shape in section. In particular, the body region 22 comprises a central portion 25, which faces the top surface Sₜₒₚ at the top and contacts the strengthening region 24 at the bottom, and a pair of peripheral portions 26', 26", which extend on opposite sides with respect to the central portion 25, in an approximately symmetrical manner with respect to the symmetry plane. The peripheral portions 26', 26" protrude laterally with respect to the underlying strengthening region 24.

In greater detail, each of the peripheral portions 26', 26" faces the top surface Sₜₒₚ at the top and has a convex profile, which defines a corresponding concavity arranged facing the central portion 25.

Even more in detail, indicating with w(z) the function that represents the value of the width w of the body region 22 (parallel to the X axis) as the z coordinate, taken along the Z axis, varies, the following occurs.

At the top surface Sₜₒₚ, the function w(z) is initially equal to a value Wₜₒₚ; subsequently, as the value of the z coordinate decreases, therefore as the depth inside the semiconductor body 4 increases, the function w(z) increases its value, up to reaching a maximum value Wₘₐₓ, at a depth greater than the maximum depth reached by the first and the second source regions 30', 30"; subsequently, as the value of the z coordinate decreases, the value of the function w(z) decreases, down to reaching a value Wᵢₙᵢₜ (which represents the width of the strengthening region 24) at the plane wherein the body region 22 and the strengthening region 24 contact. Wᵢₙᵢₜ< Wₜₒₚ < Wₘₐₓ also occurs.

In other words, the body region 22 has a width which, as the depth inside the semiconductor body 4 increases, follows a non-monotonic trend, which exhibits a maximum at an intermediate depth with respect to the top surface Sₜₒₚ and the strengthening region 24.

Each body structure 20 further comprises a corresponding enriched region 23, which has a P+ type doping. In addition, the MOSFET transistor 1 comprises, for each body structure 20, a pair of corresponding source regions

(two visible in Figure 1), which have an N+ type doping, and which hereinafter are respectively referred to as the first and the second source regions 30', 30".

In detail, the first and the second source regions 30', 30" have an elongated shape parallel to the Y axis and extend inside the body region 22, starting from the top surface Sₜₒₚ, so as to be arranged at a distance parallel to the X axis, in an approximately symmetrical manner with respect to the symmetry plane H. Without any loss of generality, each of the first and the second source regions 30', 30" extends partly inside the central portion 25 of the body region 22 and partly inside a corresponding peripheral portion of the pair of peripheral portions 26', 26".

In greater detail, each of the first and the second source regions 30', 30" extends partly below a corresponding gate structure 10. In particular, each of the first and the second source regions 30', 30" comprises: a respective external portion, which extends below a portion of the gate dielectric region 12 of the corresponding gate structure 10, in direct contact; an intermediate portion, which extends below a lateral portion of the corresponding gate insulating region 16, in direct contact; and an internal portion, which extends below a corresponding portion of the source metallization 17, in direct contact. Furthermore, the first and the second source regions 30', 30" are separated laterally by a part of the central portion 25 of the body region 22.

The enriched region 23 extends inside the body region 22, at a distance from the top surface Sₜₒₚ and from the strengthening region 24 and below the first and the second source regions 30', 30"; without any loss of generality, in the example shown in Figure 1, the enriched region 23 does not contact the first and the second source regions 30', 30", although embodiments (not shown) are possible wherein the enriched region 23 contacts the first and the second source regions 30', 30".

In greater detail, the enriched region 23 has an approximately elliptical shape in section, symmetrical with respect to the symmetry plane H, and partially occupies the central portion 25 and the peripheral portions 26', 26" of the body region 22, without contacting the drain region 8; in particular, the enriched region 23 is surrounded laterally, at the top and at the bottom by the body region 22.

In even greater detail, parallel to the X axis, the enriched region 23 protrudes laterally both with respect to the first and the second source regions 30', 30"; in particular, with reference to what has been shown in Figure 1, the enriched region 23 protrudes to the left, with respect to the first source region 30', and protrudes to the right, with respect to the second source region 30". Therefore, it occurs that, parallel to the X axis, the enriched region 23 protrudes laterally in both directions with respect to the pair formed by the first and the second source regions 30', 30". Furthermore, parallel to the X axis, the enriched region 23 protrudes laterally in both directions also with respect to the underlying strengthening region 24.

In use, when the gate terminal of the MOSFET transistor 1 is biased above the threshold voltage, a pair of conductive channels is formed, in each cell 2, inside the respective body region 22. In particular, a first conductive channel extends into the peripheral portion 26' of the body region 22, starting from the first source region 30' and parallel to the XY plane, below the corresponding gate dielectric region 12; a second conductive channel extends into the peripheral portion 26" of the body region 22, starting from the second source region 30" and parallel to the XY plane, below the corresponding gate dielectric region 12.

In each cell 2 the current may therefore initially flow in the corresponding conductive channels that form in the respective body region 22; then, the current follows a vertical direction (parallel to the Z axis), inside the drain region 8, towards the drain metallization 37.

In practice, the MOSFET transistor 1 has a super-junction structure and, as previously mentioned, includes a plurality of cells 2. Furthermore, as shown in Figure 1 with reference to the second source region 30" (but the same considerations also apply to the first source region 30'), the second source region 30" forms the emitter of a parasitic bipolar transistor (shown qualitatively in Figure 1) of NPN type, whose base is formed by the enriched region 23, and whose drain is formed by the portion of the drain region 8 that contacts the peripheral portion 26" of the body region 8.

This having been said, thanks to the fact that the enriched region 23 protrudes laterally with respect to the second source region 30", it occurs that the base of the parasitic bipolar transistor has a high concentration and furthermore the distance between the drain and the emitter is high. For these reasons, the parasitic bipolar transistor has a reduced value of the parameter h_{fe}, therefore the value of current that may flow into the base of the parasitic bipolar transistor before the parasitic bipolar transistor turns on, and the MOSFET transistor 1 risks being destroyed, is particularly high. For this reason, the MOSFET transistor 1 is particularly robust, for example if tested with the so-called UIS test.

The MOSFET transistor 1 may be manufactured by the manufacturing process described hereinbelow with reference to a single cell 2, unless otherwise specified.

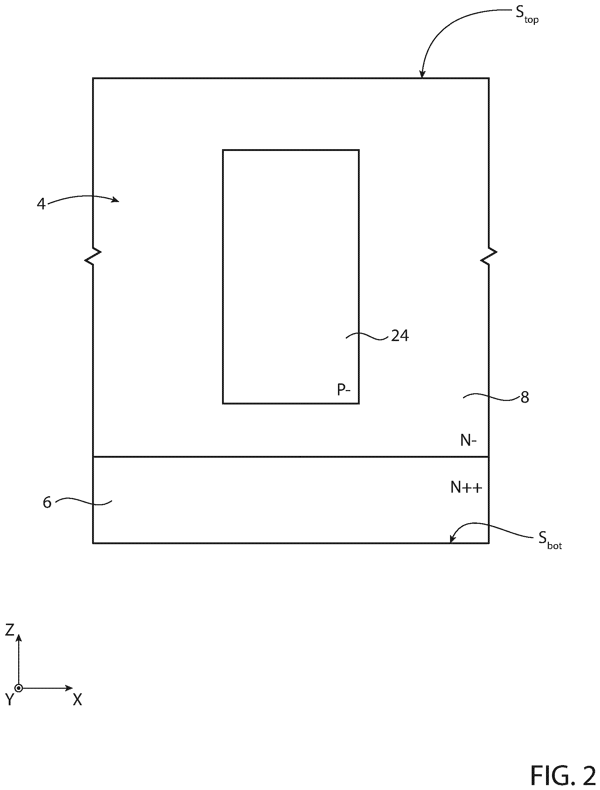

As shown in Figure 2, initially the semiconductor body 4, which comprises the substrate 6, the drain region 8 and the strengthening region 24, is formed in a known manner.

In particular, the strengthening region 24 is formed so as to be buried inside the drain region 8, at a distance from the top surface Sₜₒₚ. For example, the drain region 8 and the strengthening region 24 may be formed in a per se known manner, by performing a succession of epitaxial growths and ion implants, starting from the substrate 6; the details relating to the manufacturing of the drain region 8 and the strengthening region 24 are in any case irrelevant for the purposes of manufacturing the MOSFET transistor 1.

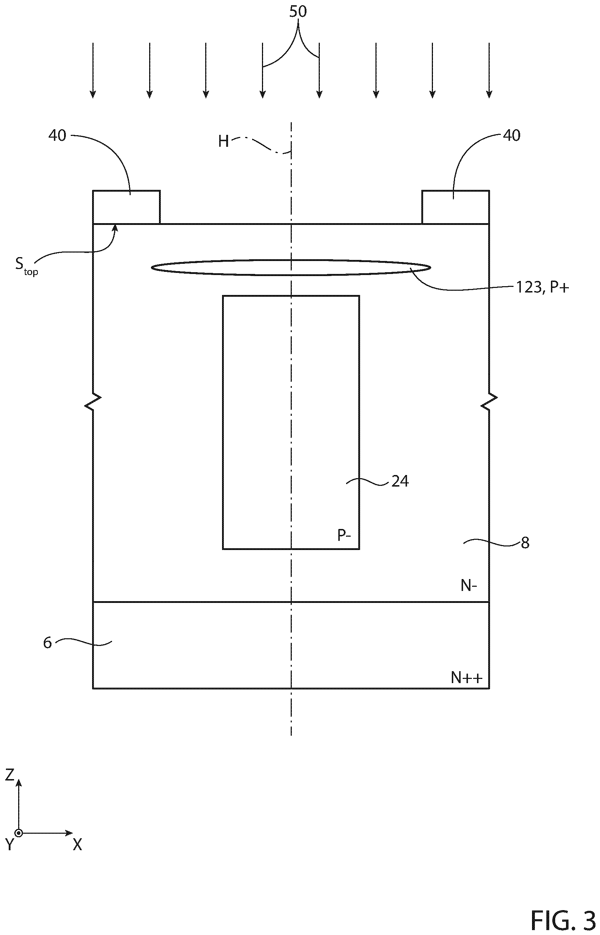

Subsequently, as shown in Figure 3, a first ion implant of P type doping species (for example, boron) is performed to form a first thin layer 123 of P+ type, which extends into the drain region 8, between the top surface Sₜₒₚ and the strengthening region 24. In particular, the first thin layer 123 extends at a distance both from the top surface Sₜₒₚ and from the strengthening region 24.

In greater detail, the aforementioned first implant is indicated in Figure 3 by the arrows 50 and may occur with a dosage for example comprised between 1*10¹³cm⁻² and 1*10¹⁵cm⁻² and with an energy for example comprised between 100KeV and 500KeV, as well as using a first resist mask 40, which is arranged above the top surface Sₜₒₚ. In particular, the first mask 40 is such that the first thin layer 123 has an elongated shape parallel to the Y axis; furthermore, the first thin layer 123 has an approximately symmetrical shape with respect to the symmetry plane H and, parallel to the X axis, it protrudes laterally in both directions with respect to the underlying strengthening region 24, therefore it has a greater width with respect to the width of the strengthening region 24.

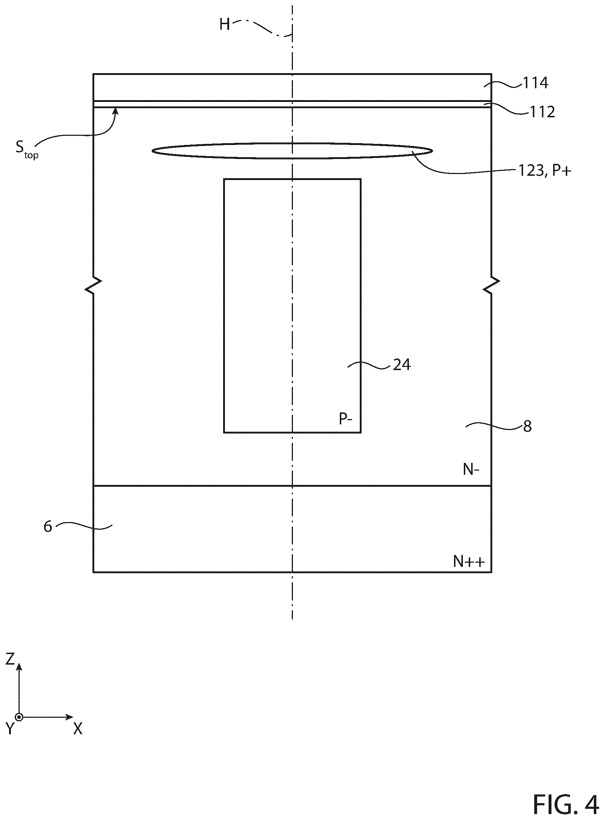

Subsequently, as shown in Figure 4, the first mask 40 is removed and a dielectric layer 112 and a conductive layer 114 are formed above the top surface Sₜₒₚ.

The dielectric layer 112 is formed for example by thermally grown oxide and extends on the top surface Sₜₒₚ, above the semiconductor body 4. The conductive layer 114 is formed for example by deposition of polysilicon and extends on the dielectric layer 112, in direct contact.

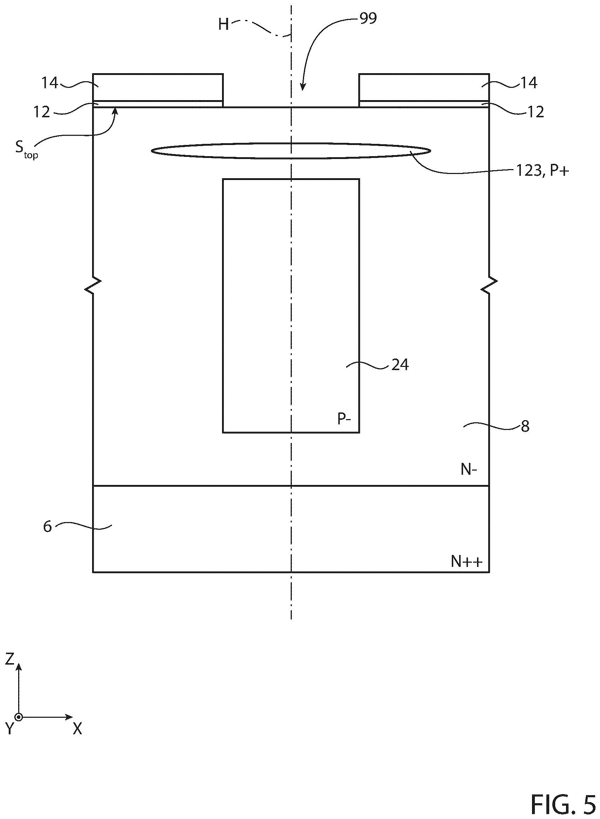

Then, as shown in Figure 5, a portion of the conductive layer 114 and an underlying portion of the dielectric layer 112 are selectively removed, so as to form a window 99 which faces a portion of the top surface Sₜₒₚ. In practice, the residual portions of the dielectric layer 112 form the gate dielectric regions 12; the residual portions of the conductive layer 114 form the gate conductive regions 14. Furthermore, the window 99 extends between the two gate dielectric regions 12 and between the two gate conductive regions 14; the window 99 has an approximately symmetrical shape with respect to the symmetry plane H.

In greater detail, the window 99 has an elongated shape parallel to the Y axis and overlies, at a distance, the strengthening region 24. Furthermore, parallel to the X axis, the window 99 has a smaller width than the width of the first thin layer 123. Without any loss of generality, in the example shown in Figure 5, the window 99 has approximately the same width as the strengthening region 24.

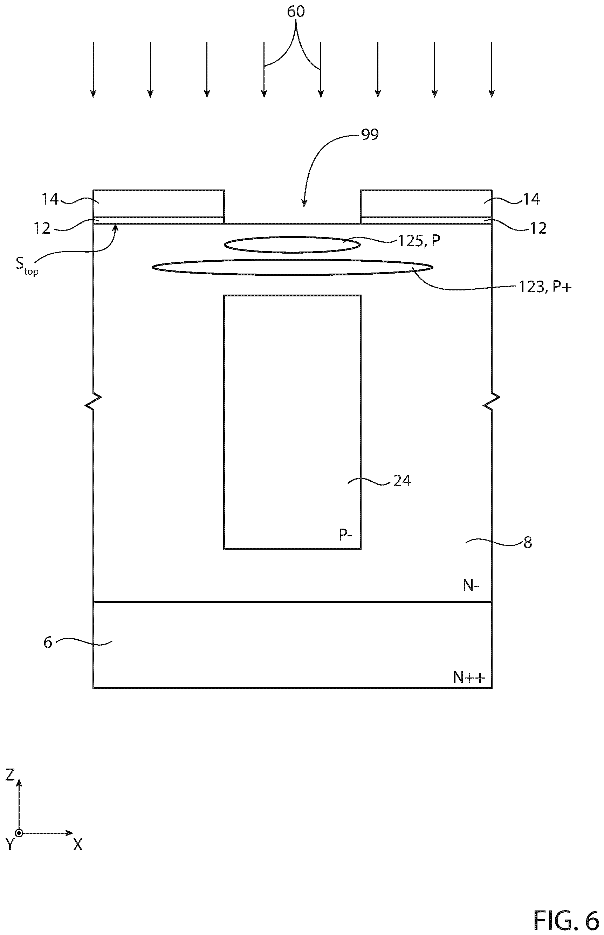

Subsequently, as shown in Figure 6, a second ion implant of P type doping species (for example, boron) is performed, to form a second thin layer 125 of P type, which extends into the drain region 8, between the top surface Sₜₒₚ and the first thin layer 123. In particular, the second thin layer 125 extends at a distance both from the top surface Sₜₒₚ and from the underlying first thin layer 123.

In greater detail, the aforementioned second implant is indicated in Figure 6 by the arrows 60 and may occur with a dosage for example comprised between 1*10¹²cm⁻² and 1*10¹⁴cm⁻² and with an energy for example comprised between 60KeV and 300KeV, through the window 99. Consequently, the second thin layer 125 has an elongated shape parallel to the Y axis, approximately symmetrical with respect to the symmetry plane H; furthermore, parallel to the X axis, the second thin layer 125 has a smaller width with respect to the width of the first thin layer 123. Consequently, parallel to the X axis, the first thin layer 123 protrudes laterally in both directions, with respect to the overlying first thin layer 125. Furthermore, without any loss of generality, the second thin layer 125 has approximately the same width as the strengthening region 24.

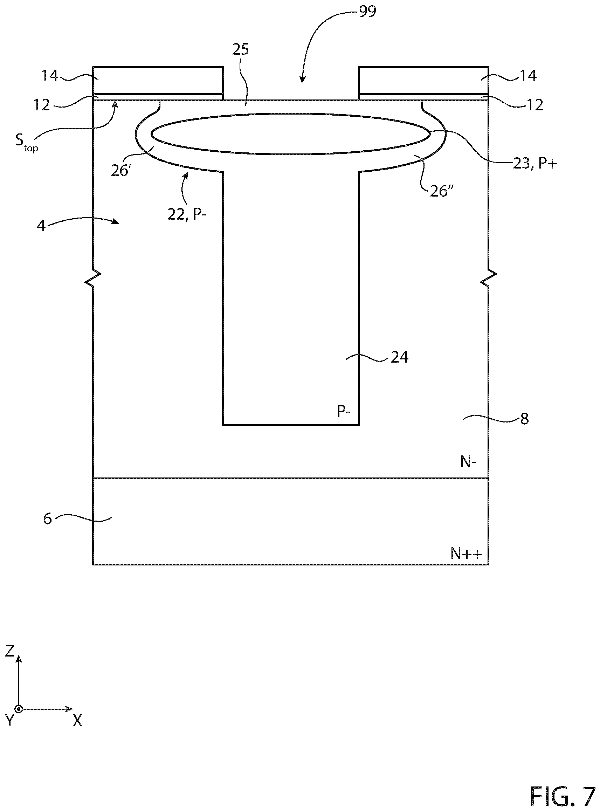

Then, a thermal treatment is performed, for example having a duration comprised between one hour and four hours and at a temperature for example comprised between 900°C and 1200°C. In this manner, there occurs a diffusion of the doping species that form the first and the second thin layers 123, 125. In particular, as shown in Figure 7, the diffusion of the doping species that form the first and the second thin layers 123, 125 causes the formation of the body region 22 and the enriched region 23.

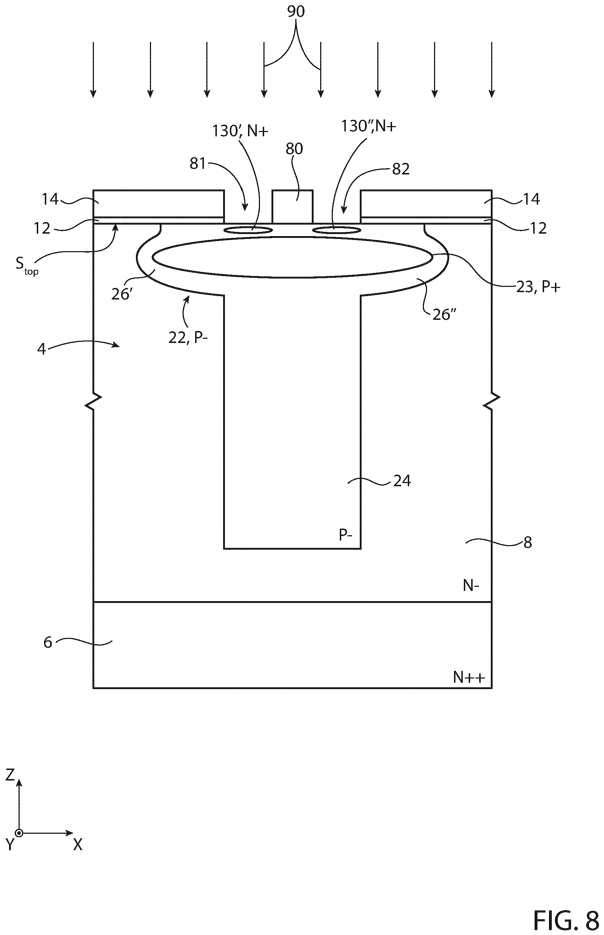

Then, as shown in Figure 8, a second mask 80 is formed inside the window 99, which laterally delimits a first and a second opening 81, 82, which are laterally offset parallel to the X axis, extend on opposite sides of the second mask 80 and face corresponding portions of the top surface Sₜₒₚ. In particular, the first opening 81 is laterally delimited by the second mask 80 and by one of the two gate dielectric regions 12 and by the overlying gate conductive region 14, while the second opening 82 is laterally delimited by the second mask 80 and by the other of the two gate dielectric regions 12 and the overlying gate conductive region 14.

Subsequently, as shown again in Figure 8, a third ion implant of N type doping species (for example, phosphorus) is performed, to form, respectively through the first and the second openings 81, 82, a third and a fourth thin layer 130', 130" of N+ type, which are laterally offset along the X axis and extend into the body region 22, between the top surface Sₜₒₚ and the enriched region 23, at a distance from the latter.

In greater detail, the aforementioned third implant is indicated in Figure 8 by the arrows 90 and may occur with a dosage for example comprised between 10¹⁵cm⁻² and 10¹⁶cm⁻² and with energy for example comprised between 60KeV and 150KeV.

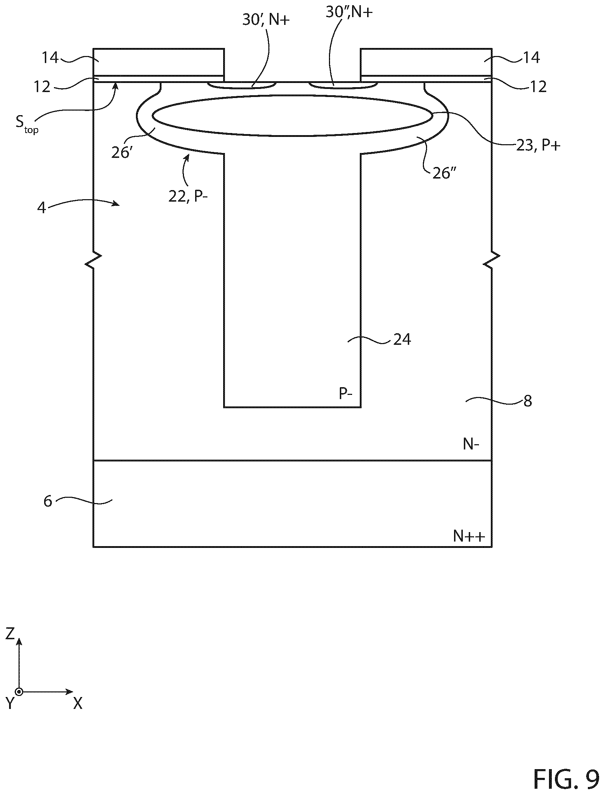

Then, as shown in Figure 9, the second mask 80 is removed and a further thermal treatment is performed, for example having a duration comprised between 15 minutes and 60 minutes and at a temperature for example comprised between 900°C and 1100°C. In this manner, there occurs a diffusion of the doping species that form the third and the fourth thin layers 130', 130", which transform respectively into the first and the second source regions 30', 30". Furthermore, as a first approximation, this further thermal treatment has a negligible impact on the body region 22 and on the enriched region 23.

Then, the manufacturing process may proceed in a manner known per se and therefore not shown, to form the gate insulating regions 16, the source metallization 17 and the drain metallization 37.

The advantages that the present MOSFET transistor affords in terms of reducing the risk of turning on the parasitic bipolar transistor are clear from the preceding description. Furthermore, thanks to the shape of the body region, the present MOSFET transistor is characterized by a reduction in the electric field below the gate dielectric regions, with a consequent reduction in charge injection into the gate-drain capacitor; it is also possible to demonstrate that a reduction in the Miller effect occurs, with a consequent reduction in energy dissipation and increase in switching efficiency.

Finally, it is clear that modifications and variations may be made to the MOSFET transistor previously described and to the related manufacturing process, without departing from the scope of the present invention, as defined in the attached claims.

For example, the doping types may be inverted with respect to what has been described. Furthermore, the materials may differ from what has been described.

## Claims

1. A MOSFET transistor comprising a semiconductor body (4) including a drain region (8) of a first conductivity type, delimited by a front surface (Sₜₒₚ), said MOSFET transistor (1) further comprising at least one cell (2) comprising:
- a pair of gate structures (10) laterally offset parallel to a first axis (X) and each including a respective gate dielectric region (12), arranged on the front surface (Sₜₒₚ), and a respective gate conductive region (14), arranged on the corresponding gate dielectric region (12);
- a body structure (20) of a second conductivity type, which comprises a body region (22), which extends inside the drain region (8) starting from the front surface (Sₜₒₚ) and contacts portions of the gate dielectric regions (12), and a strengthening region (24), which extends inside the drain region (8), below the body region (22); and
- a pair of source regions (30',30") of the first conductivity type, which extend inside the body region (22) starting from the front surface (Sₜₒₚ) and contact, each, a corresponding gate dielectric region (12);
and wherein the body structure (20) comprises an enriched region (23), which has a doping level greater than the doping level of the body region (22) and extends inside the body region (22), below the source regions (30',30"); and wherein, parallel to the first axis (X), the enriched region (23) protrudes laterally in both directions with respect to the pair of source regions (30',30").

2. The MOSFET transistor according to claim 1, wherein the body region (22) has a rounded shape; and wherein the width of the body region (22), measured parallel to the first axis (X), has a non-monotonic trend as the depth increases and has a maximum (Wₘₐₓ) at a depth greater than the maximum depth reached by the source regions (30',30").

3. The MOSFET transistor according to any of the preceding claims, wherein, parallel to the first axis (X), the enriched region (23) protrudes laterally in both directions also with respect to the strengthening region (24) .

4. The MOSFET transistor according to any of the preceding claims, wherein the gate structure (10), the body structure (20) and the source regions (30',30") have elongated shapes parallel to a second axis (Y) perpendicular to the first axis (X).

5. The MOSFET transistor according to any of the preceding claims, wherein the strengthening region (24) has a doping level lower than the doping level of the enriched region (23).

6. The MOSFET transistor according to any of the preceding claims, wherein the first conductivity type is an N type conductivity; and wherein the second conductivity type is a P type conductivity.

7. A process for manufacturing a MOSFET transistor comprising forming a semiconductor body (4) including a drain region (8) of a first conductivity type, delimited by a front surface (Sₜₒₚ), and forming at least one cell (2); and wherein forming at least one cell (2) comprises:
- forming a pair of gate structures (10) laterally offset parallel to a first axis (X) and each including a respective gate dielectric region (12), arranged on the front surface (Sₜₒₚ), and a respective gate conductive region (14), arranged on the corresponding gate dielectric region (12);
- forming a body structure (20) of a second conductivity type, wherein forming the body structure (20) comprises forming a body region (22), which extends inside the drain region (8) starting from the front surface (Sₜₒₚ) and contacts portions of the gate dielectric regions (12), and forming a strengthening region (24), which extends inside the drain region (8), below the body region (22); and
- forming a pair of source regions (30',30") of the first conductivity type, which extend inside the body region (22) starting from the front surface (Sₜₒₚ) and contact, each, a corresponding gate dielectric region (12);
and wherein forming the body structure (20) further comprises forming an enriched region (23), which has a doping level greater than the doping level of the body region (22) and extends inside the body region (22), below the source regions (30',30"); and wherein, parallel to the first axis (X), the enriched region (23) protrudes laterally in both directions with respect to the pair of source regions (30',30").

8. The manufacturing process according to claim 7, comprising:
- after forming the strengthening region (24) and before forming the gate structures (10), forming, by a first implant of doping species of the second conductivity type, a first implanted layer (123), which extends into the drain region (8), between the front surface (Sₜₒₚ) and the strengthening region (24); and subsequently
- forming the gate dielectric regions (12) and the gate conductive regions (14); and subsequently
- by a second implant of doping species of the second conductivity type, forming a second implanted layer (125), which extends into the drain region (8), between the front surface (Sₜₒₚ) and the first implanted layer (123); and subsequently
- performing a first thermal treatment, so as to cause the diffusion of the doping species of the first and the second implanted layers (123,125) and the consequent formation of the body region (22) and the enriched region (23) .

9. The manufacturing process according to claim 8, wherein said second implant is performed through a window (99) formed by the gate dielectric regions (12) and the gate conductive regions (14).

10. The manufacturing process according to claim 8 or 9, wherein forming the first implanted layer (123) comprises performing said first implant through a mask (40), which is arranged on the front surface (Sₜₒₚ) and is such that, parallel to the first axis (X), the first implanted layer (123) protrudes laterally in both directions with respect to the strengthening region (24).

11. The manufacturing process according to any of claims 8 to 10, wherein forming the second implanted layer (125) comprises forming the second implanted layer (125) so that, parallel to the first axis (X), the first implanted layer (123) protrudes laterally in both directions with respect to the second implanted layer (125).

12. The manufacturing process according to any of claims 8 to 11, wherein forming the pair of source regions (30',30") comprises:
- following the first thermal treatment, forming, by a third implant of doping species of the first conductivity type, a third and a fourth implanted layer (130',130"), which extend inside the body region (22), above the enriched region (23); and subsequently
- performing a second thermal treatment, so as to cause the diffusion of the doping species of the third and the fourth implanted layers (130',130") and the consequent formation of the source regions (30',30").
